# EUROPEAN PATENT SPECIFICATION

(11) **EP 0 577 896 B1**
(45) Date of publication and mention of the grant of the patent: **20.05.1998**
(21) Application number: 92311466.4
(22) Date of filing: 16.12.1992
(51) Int. Cl.: H03F 3/08, H04B 10/14

(54) **Preamplifier**
Vorverstärker
Préamplificateur

(30) Priority: 10.07.1992 JP 207317/92
(43) Date of publication of application: 12.01.1994
(73) Proprietor: MITSUBISHI DENKI KABUSHIKI KAISHA, Tokyo (JP)
(72) Inventor: Miyashita, Miyo, c/o Mitsubishi Denki K.K., Itami-shi, Hyogo 664 (JP)
(74) Representative: Beresford, Keith Denis Lewis

(56) References cited:
- EP-A- 0 177 217
- DE-A- 3 223 218
- US-A- 4 218 613
- PATENT ABSTRACTS OF JAPAN vol. 10, no. 197 (E-418)(2253) 10 July 1986

## Description

### FIELD OF THE INVENTION

The present invention relates to a preamplifier and, more particularly to a preamplifier constituting an optical receiver employed for an optical linking system and so on.

### BACKGROUND OF THE INVENTIONS

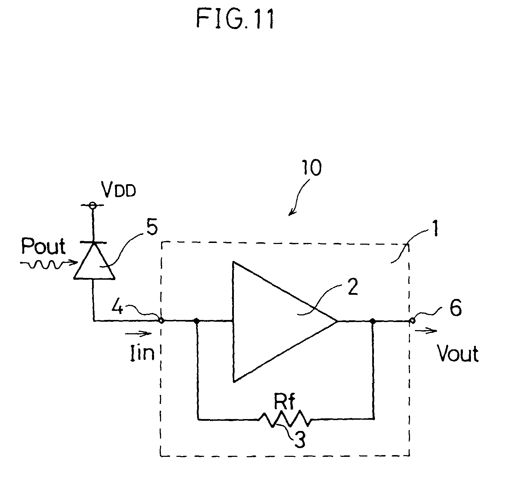

Figure 11 is a block diagram showing a constitution of an optical receiver employing a prior art transimpedance type preamplifier. In the Figure, a receiver 10 comprises a transimpedance type preamplifier 1 and a photodiode 5 a p-side electrode of which is connected to an input of the transimpedance type preamplifier 1. The transimpedance type preamplifier 1 comprises a voltage amplifier 2 and a feedback resistor 3 which is attached to the voltage amplifier 2 outside thereof. That is, the feedback resistor 3 is connected in parallel between an input and output of the voltage amplifier 2 so as to feedback a part of the output signal of the voltage amplifier 2 to the input side. Reference numeral 4 designates an input terminal and numeral 6 designates an output terminal. Reference character Pₒᵤₜ shows light, reference character Iᵢₙ shows a current signal from the photodiode 5 and reference character Vₒᵤₜ shows a voltage signal output from the preamplifier 1.

A description is given of the operations.

Light Pₒᵤₜ entering into the photodiode 5 is converted into a current signal Iᵢₙ through the photodiode 5 and enters into the preamplifier 1 from the input terminal 4. The current signal Iᵢₙ flows into the feedback resistor 3 if the input impedance of the voltage amplifier 2 is sufficiently high. In this case, when a gain of the voltage amplifier 2 is sufficiently high, supposed that the resistance value of the feedback resistor 3 be Rf[Ω] and the current signal amplitude be ΔIᵢₙ, the output voltage amplitude ΔVₒᵤₜ is represented as follows:${\text{ΔV}}_{\text{out}} {\text{= ΔI}}_{\text{in}} \text{·Rf.}$ In addition, the noise of the optical receiver 10 comprising the photodiode 5 and the preamplifier 1 is represented by the converted into input noise current density (unit:[A/ $\sqrt{\text{Hz}}$]). This noise is controlled by a thermal noise due to the feedback resistor 3 and a channel noise of a source grounded field effect transistor (hereinafter referred to as FET) in the voltage amplifier 2. The thermal noise <i_{Rf}2> (unit:[A/$\sqrt{\text{Hz}}$]) due to the feedback resistor 3 is represented as follows:${\text{<i}}_{\text{Rf}} \text{2> =} \frac{\text{4KT}}{\text{Rf}} \text{Δf ,}$ where T is absolute temperature, K is Boltzmann's constant, and Δf is operation band width.

On the other hand, 3dB band of the optical receiver 10 (f_{3dB}) is, supposed that a capacitance of the photodiode 5 be C_{pd}, an input capacitance of the preamplifier 1 be Cᵢₙ and a voltage gain of the voltage amplifier 2 be A, represented as follows:${\text{f}}_{\text{3dB}} \text{=} \frac{\text{A}}{{\text{2π(C}}_{\text{pd}} {\text{+C}}_{\text{in}} \text{)Rf}} \text{.}$

According to these formulae, in order to enhance the sensitivity of the optical receiver 10 comprising the photodiode 5 and the preamplifier 1, it is effective to increase the feedback resistance value Rf of the feedback resistor 3 in the preamplifier 1 thereby to enhance the sensitivity of the preamplifier 1 while keeping a necessary band.

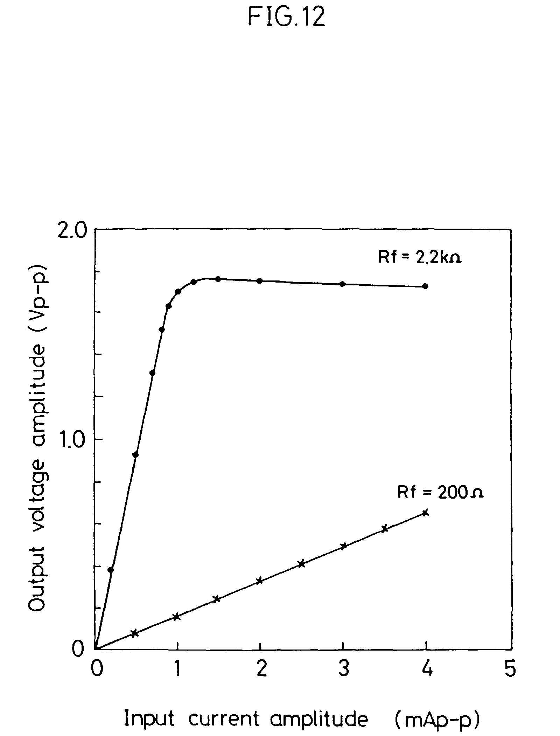

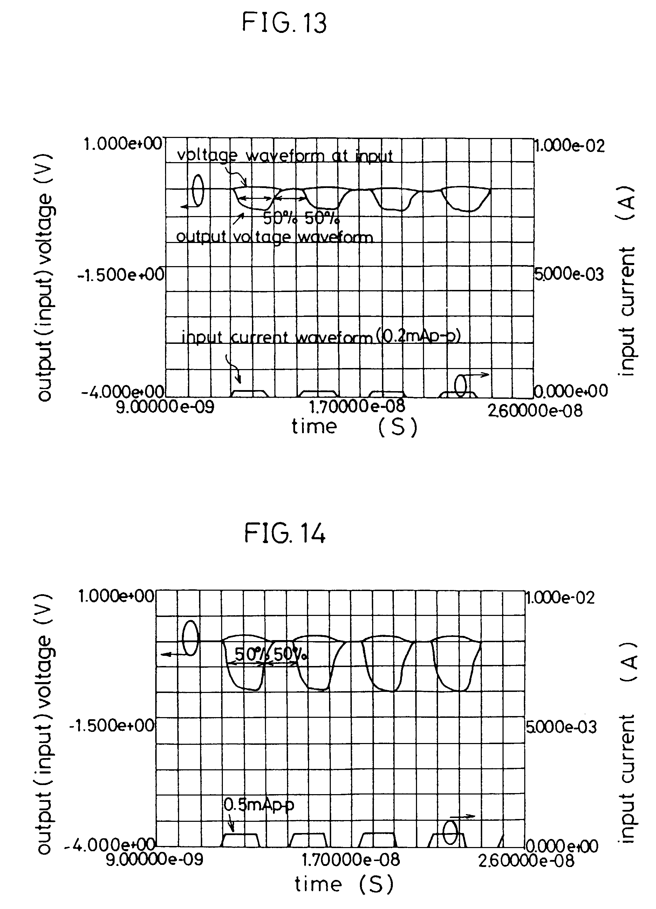

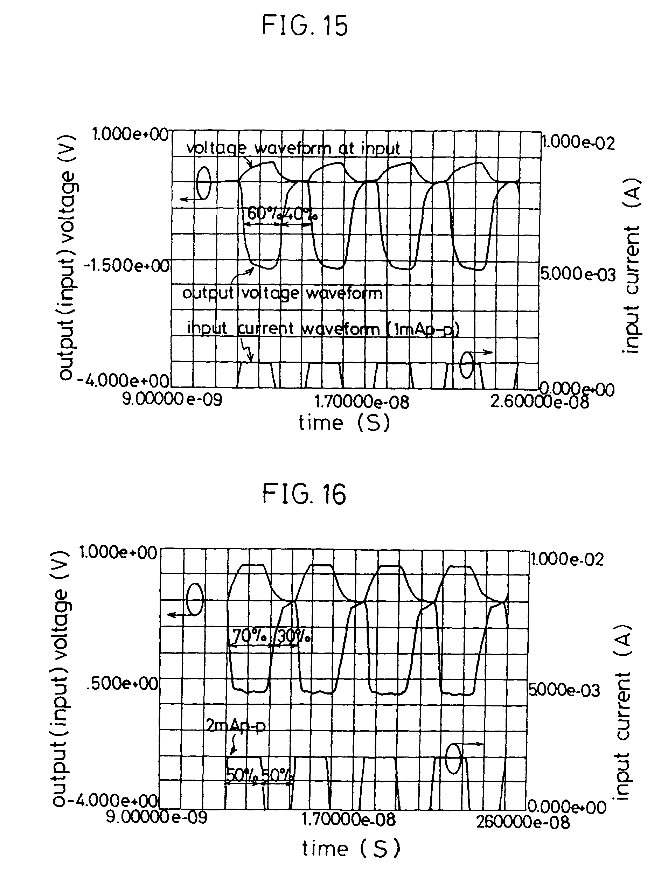

Figure 12 shows the characteristic of the output voltage amplitude against the input current amplitude of the preamplifier 1. In the Figure, a curve obtained by connecting between points of black dot • shows the output voltage amplitude against the input current amplitude when the feedback resistance value Rf is 2.2kΩ in a transmission speed of 622 Mb/s and a curve obtained by connecting between points of crossed mark × shows the output voltage amplitude against the input current amplitude when the feedback resistance value Rf is 200Ω in a transmission speed of 622 Mb/s. Figures 13 to 16 are diagrams showing an output voltage waveform against an input current amplitude when the feedback resistance value Rf is 2.2kΩ and the input current amplitude is 0.2mAp-p, 0.5mAp-p, 1mAp-p or 2mAp-p, respectively. From these Figures, it is apparent that, although it is, as described above, effective to increase the feedback resistance value Rf of the feedback resistor 3 in the preamplifier 1 to enhance the sensitivity of the preamplifier 1, the input dynamic range is reduced due to an increase in the input impedance and the duty ratio of an output voltage signal unfavorably changes, more particularly, the output voltage signal is unfavorably distorted, when a large signal, namely an input current having a large amplitude is input as particularly shown in Figures 15 and 16.

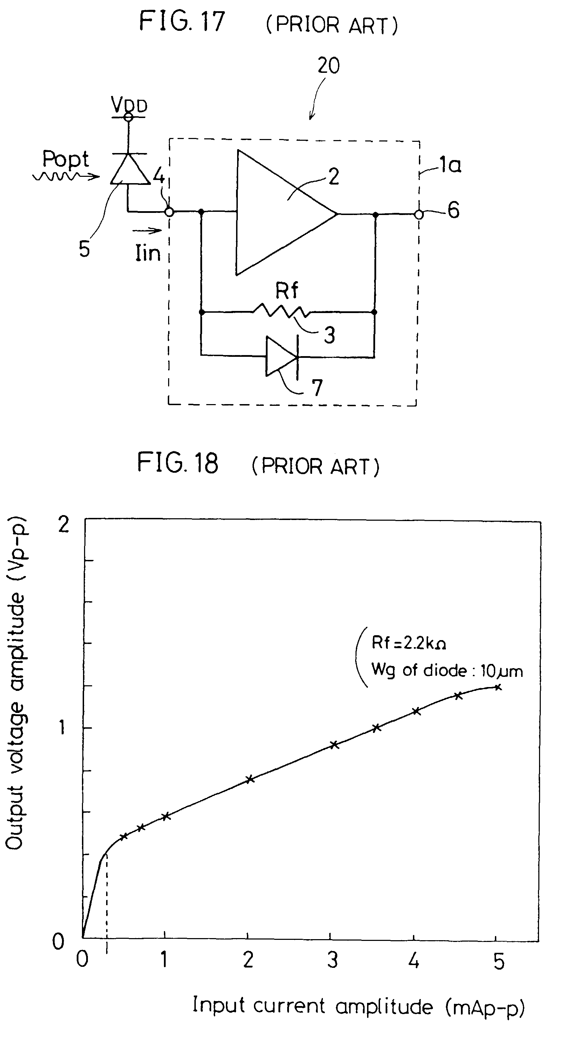

Disclosed in Japanese Published Patent Application No.3-54905 is a preamplifier in which the substantive feedback resistance value is changed between inputting a large signal and inputting a small signal so as to enlarge the input dynamic range, thereby enabling obtaining an output voltage signal without a distortion when a large signal is input. Figure 17 is a block diagram showing a constitution of an optical receiver in which a diode is connected in parallel with a feedback resistor constituting the preamplifier similarly as the optical receiver disclosed in Japanese Published Patent Application No.3-54905. In the Figure, the same reference numerals as those of Figure 11 designate the same or corresponding parts. A receiver 20 comprises a preamplifier la and the photodiode 5. In the preamplifier 1a, a diode 7 is connected in parallel with the feedback resistor 3 so that an anode of the diode 7 may be connected to an input terminal 4 and a cathode thereof to an output terminal 6.

Next, a description is given of the operation.

Almost all of the current signal Iᵢₙ from the photodiode 5 flows into the feedback resistor 3 similarly as the optical receiver 10 shown in Figure 11, and when a voltage drop of the feedback resistor 3 is less than a rising up voltage of a forward direction current of the diode 7 connected in parallel, a current almost flows into the feedback resistor 3 and the same operation as in the case with no diode 7 is performed. When the voltage drop of the feedback resistor 3 exceeds the rising up voltage of the forward direction current, a current also begins to flow into the diode 7 and supposed that a resistance value when the diode 7 is "on" state be Rdf, the actual feedback resistance value is represented as follows:$\text{Rfs =} \frac{\text{Rf·Rdf}}{\text{Rf+Rdf}} \text{.}$ Particularly, when Rf>>Rdf, the feedback resistance value Rfs is reduced to a value represented by the following formula (5) and the dynamic range is enlarged by that degree.$\text{Rfs=Rdf .}$

Figure 18 shows a characteristic of the output voltage amplitude against the input current amplitude of the preamplifier 1a when the feedback resistance value Rf of the feedback resistor 3 is 2.2kΩ and an internal resistance Rdf of the diode 7 in "on" state is fixed at 180Ω in a transmission speed of 622 Mb/s. The rising up voltage of the forward direction current (Schottky barrier voltage) of the diode 7 is determined dependent on a material of the diode 7. Here, a Schottky diode formed on a GaAs substrate is employed and the rising up voltage of the forward direction current (Schottky barrier voltage) is approximately 0.6V.

As is apparent from the Figure, when the input current amplitude to the preamplifier 1a is within 0.0 to 0.3 mAp-p, since the voltage drop in the feedback resistor 3 is equal to or less than 0.6V, few current flows into the diode and the gain at transformation between an input current and an output voltage, namely, a transimpedance gain is almost determined by the feedback resistance value (2.2kΩ) of the feedback resistor 3 and the noise characteristic is almost the same as that of a case without the diode 7. However, when the input current amplitude is over 0.3 mAp-p, the voltage drop in the feedback resistor 3 is larger than 0.6V and the diode 7 is "on" state. At this time, the feedback resistance value Rf of the feedback resistor 3 is sufficiently larger than the internal resistance value Rdf of the diode and the transimpedance gain becomes almost equal to the internal resistance value Rdf of the diode (180 Ω) and the input dynamic range is enlarged to 5 mAp-p while that is about 1 mAp-p without the diode 7 (refer to Figure 12).

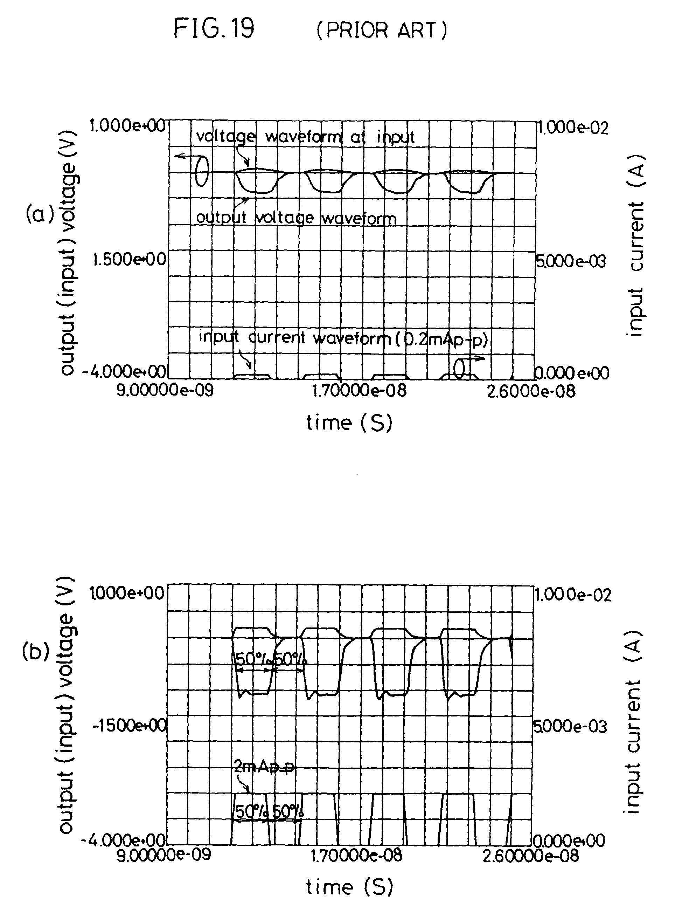

Figures 19(a) and 19(b) are diagrams showing an input current waveform and an output voltage waveform in the preamplifier 1a in the above-described operation. Figure 19(a) shows an input current waveform and an output voltage waveform when the input current amplitude is 0.2 mAp-p and Figure 19(b) shows an input current waveform and an output voltage waveform when the input current amplitude is 2.0 mAp-p. As shown in the Figures, while in the preamplifier 1 shown in Figure 11 the duty of the output voltage waveform varies when the input current amplitude increases to 2 mAp-p, the duty does not vary even when the input current amplitude increases to 2 mAp-p in this preamplifier 1a, resulting in an output signal with no distortion.

In the prior art preamplifier constituted as described above, a diode is connected in parallel with the feedback resistor so as to prevent the lowering of the output voltage when a large signal, namely, an input current having a large amplitude, is input, thereby enlarging the input dynamic range.

In the construction where a single diode 7 is connected in parallel with the feedback resistor 3, however, because the threshold voltage of the forward direction current of the diode connected in parallel with the feedback resistor is determined dependent on a material of the diode as described above, while it is possible to enlarge the dynamic range, an input signal level by which the diode is turned on, that is, an input signal level where a substantive feedback resistance value is switched, is fixed. Therefore, even if it is desirable to obtain a voltage amplitude above a certain level as a sensitivity of the amplifier when a small signal is input (for example, when a signal in a range from 0.5 to 1.0 mAp-p is input), a desired voltage value cannot be obtained when a switching point of the substantive feedback resistance value is at a signal level smaller than this input signal.

In addition, since as a characteristic of a diode, few current flows through the diode during when the voltage does not exceed the Schottky barrier voltage and a current suddenly flows when the forward direction voltage exceeds the Schottky barrier voltage, that is, when the diode is turned on, the substantive feedback resistance value also varies suddenly before and after the diode is turned on. As a result, there is a problem that a linear characteristic of an amplification factor is poor and a device which is connected to the amplifier at a latter stage thereof should malfunction.

EP-A-0177217 discloses a preamplifier for an optical receiver including a voltage amplifier having a series arrangement of two resistors connected in parallel between the input terminal and output terminal of the voltage amplifier. Two diodes are connected in series to each other and in parallel with the feedback resistors.

DE-A-3223218 discloses a preamplifier for an optical receiver including a voltage amplifier with a series arrangement of two feedback resistors connected against the input and output terminal of the amplifier. A transistor is used to alter the feedback resistance in order to protect the amplifier against over modulation.

JP-A-61041213 and Patent Abstracts of Japan, Vol 10, No. 197 (E-418) (2253) discloses an amplifier having a feedback resistor connected between the input and output of the amplifier. An FET is connected in parallel with the feedback resistor. The feedback resistance is thus determined by the resistor and the resistance of the FET.

### SUMMARY OF THE INVENTION

It is an object of the present invention to provide a preamplifier having superiority in practical use in that not only an input dynamic range is enlarged, but also an input signal level at which a substantive feedback resistance value is switched, can be adjusted to at a desirable level at the production of the preamplifier or before the use thereof.

It is another object of the present invention to provide a preamplifier than can not only enlarge an input dynamic range but also provide an amplification operation close to a linear operation.

Other objects and advantages of the present invention will become apparent from the detailed description given hereinafter; it should be understood, however, that the detailed description and specific embodiment are given by way of illustration only, since various changes and modifications within the spirit and scope of the invention will become apparent to the those skilled in the art from this detailed description.

According to a first aspect of the present invention, there is provided an optical receiver preamplifier for converting an input photo current signal into a voltage signal and outputting the voltage signal, comprising:
a voltage amplifier;
a feedback resistor connected in parallel between an input terminal and an output terminal of said voltage amplifier; and
a plurality of diodes which are connected in series to each other and are connected in parallel with said feedback resistor so that an anode side of the diodes is connected at an input side of said voltage amplifier and a cathode side of the diodes is connected at an output side of said voltage amplifier, characterised in that
said feedback resistor comprises a plurality of resistors connected in series and said diodes are connected in parallel with one of said resistors.

In one embodiment of a preamplifier according to the first aspect of the present invention, a fuse is connected in parallel with each of the diodes. Or, a bonding pad is connected to each of the input and the output side of the diodes so as to enable conducting wire bonding for short-circuiting each of the diodes. Further, an FET is connected in parallel with each of the diodes. As a result, since it is possible to selectively switch each of the plurality of diodes into "on" state where an input signal passes through, an input signal level at which a substantive feedback resistance value is switched, can be determined with paying consideration on the sensitivity and the amplification factor of the amplifier, or the matching with an external apparatus, in practical use.

According to a second aspect of the present invention, there is provided an optical receiver preamplifier for converting an input photo current signal into a voltage signal which is to be output, comprising:
a voltage amplifier; and
a feedback resistor connected in parallel between an input terminal and output terminal of said voltage amplifier, characterised in that
said feedback resistor comprises a plurality of resistors which are connected in series to each other and connected in parallel between an input terminal and an output terminal of said voltage amplifier; and characterised in that
an enhancement type field effect transistor which is connected in parallel with one of said resistors of said feedback resistor so that a drain and a gate of said enhancement type field effect transistor are connected at an input side of said voltage amplifier and a source thereof is connected at an output side of said voltage amplifier.

As a result, the amplification factor does not change rapidly before and after the substantive feedback resistance value is switched, and an amplification operation can be made close to a liner operation.

### BRIEF DESCRIPTION OF THE DRAWINGS

Figure 1 is a block diagram showing a constitution of an optical receiver employing a preamplifier in accordance with a first embodiment of the present invention.

Figure 2 is a block diagram showing a concrete circuit constitution of the preamplifier of Figure 1.

Figure 3 is a diagram showing an input and an output characteristic of the preamplifier of Figure 1 as compared with a prior art preamplifier.

Figure 4 is a diagram showing an input and an output characteristic of the preamplifier of Figure 1.

Figure 5 is a block diagram showing a constitution of a preamplifier in accordance with a second embodiment of the present invention.

Figure 6 is a block diagram showing a constitution of a preamplifier in accordance with a third embodiment of the present invention.

Figure 7 is a block diagram showing a constitution of a preamplifier in accordance with a fourth embodiment of the present invention.

Figure 8 is a block diagram showing a constitution of an optical receiver employing a preamplifier in accordance with a fifth embodiment of the present invention.

Figure 9 is a diagram showing a voltage and a current characteristic of an enhancement type FET of Figure 8.

Figure 10 is a diagram showing an input and an output characteristic of the preamplifier of Figure 8.

Figure 11 is a block diagram showing a constitution of an optical receiver employing a prior art preamplifier.

Figure 12 is a diagram showing an input and an output characteristic of the preamplifier of Figure 11.

Figure 13 is a diagram showing an input and an output waveforms of the preamplifier of Figure 11.

Figure 14 is a diagram showing an input and an output waveforms of the preamplifier of Figure 11.

Figure 15 is a diagram showing an input and an output waveforms of the preamplifier of Figure 11.

Figure 16 is a diagram showing an input and an output waveforms of the preamplifier of Figure 11.

Figure 17 is a block diagram showing a constitution of an optical receiver employing a prior art preamplifier.

Figure 18 is a diagram showing an input and an output characteristic of the preamplifier of Figure 17.

Figures 19(a) and 19(b) are diagrams showing an input and an output waveforms of the preamplifier of Figure 17.

### DETAILED DESCRIPTION OF THE PREFERRED EMBODIMENT

Embodiments of the present invention will be described in detail with reference to the drawings.

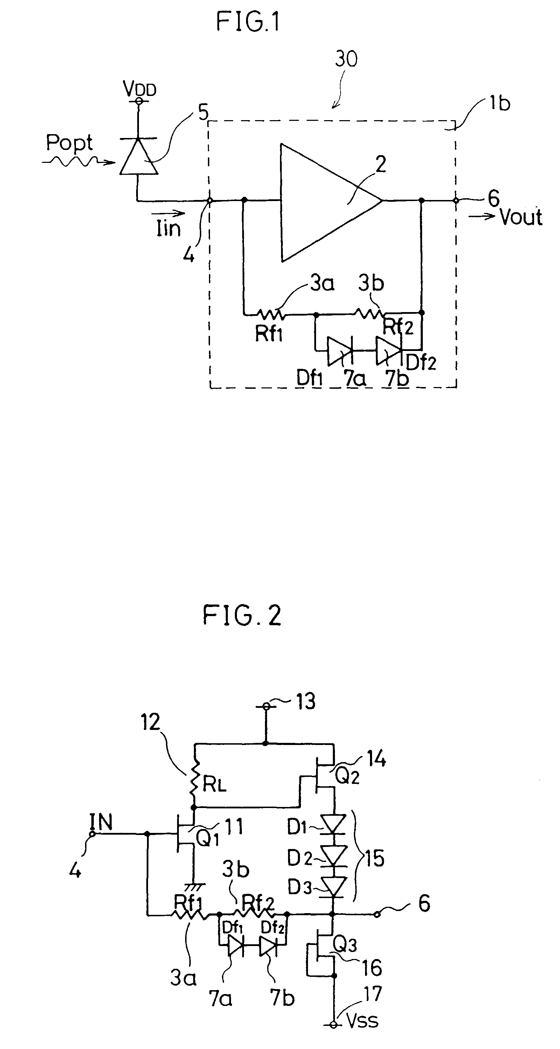

Figure 1 is a block diagram showing an optical receiver employing a preamplifier in accordance with a first embodiment of the present invention. In the figure, the same reference numerals as those of Figure 11 designate the same or corresponding parts. An optical receiver 30 comprises a preamplifier 1b and the photodiode 5. The preamplifier 1b includes the voltage amplifier 2, feedback resistors 3a and 3b which are connected in parallel with the voltage amplifier 2 and in series to each other, and diodes 7a and 7b which are connected in series to each other and are connected in parallel with the feedback resistor 3b with an anode side of the two diodes at the side of the input terminal 4 and a cathode side thereof at the side of the output terminal 6. Here, diodes 7a and 7b are Schottky barrier diodes formed on a GaAs substrate and a rising up voltage of a forward direction current of each diode 7a, 7b (Schottky barrier voltage) is approximately 0.6V, similarly as the above-described diode 7.

Figure 2 is a block diagram showing a circuit constitution of the preamplifier 1b. The preamplifier 1b includes the following: a source grounded FET 11(Q1) of which gate is connected to the input terminal 4, a source follower FET 14(Q2) of which gate is connected to a drain of the source grounded FET 11(Q1) and which realizes a level shift of an output voltage of the source grounded FET 11(Q1), a load resistance RL12 connected between a power supply 13 to which the drain of the source follower FET 14(Q2) is connected and the drain of the source grounded FET 11(Q1), a constant current source FET 16(Q3) which source and gate are connected to a substrate potential 17(Vss), level shift diodes 15(D1 to D3) which are connected between the source of the source follower FET 14(Q2) and the constant current source FET 16(Q3) with its anode side thereof directed to the source side of the source follower FET 14(Q2) and its cathode side directed to the drain side of the constant current source FET 16(Q3), feedback resistors 3a and 3b which are connected in series between the connection node of the level shift diodes 15(D1 to D3) with the drain of the constant current source FET 16(Q3) and the connection node of the gate of the source grounded FET 11(Q1) with the input terminal 4, functioning to return an output voltage of the level shift diodes 15(D1 to D3) at a cathode of the diode D3 to the gate of the source grounded FET 11(Q1), and diodes 7a and 7b which are connected in series to each other and are connected in parallel with the feedback resistor 3b.

Next, a description is given of operations.

The fundamental operations are the same as those of the prior art optical receiver 20 shown in Figure 17.

In this preamplifier 30, since a rising up voltage of a forward direction current (Schottky barrier voltage) of the diodes 7a and 7b is approximately 0.6V as described above and these diodes are connected in series to each other in order that a current flows through the diodes 7a and 7b, a voltage drop in the feedback resistor 3b must be above 1.2V (=0.6V×2). In this case, supposed that resistance values of the feedback resistors 3a and 3b respectively be Rf1 and Rf2 and resistance values of the diodes 7a and 7b in "on" state be Rdf1 and Rdf2, a substantive feedback resistance value Rfs is represented as follows:$\text{Rfs = Rf1 +} \frac{\text{Rf2 Rdf1 + Rf2 Rdf2}}{\text{Rf2 + Rdf1 + Rdf2}} \text{.}$ Particularly, when Rf2>>(Rdf1+Rdf2) , since the feedback resistance value Rfs is reduced to a value represented by the following formula (7), a dynamic range can be enlarged by that degree.$\text{Rfs = Rf1 + Rdf1 + Rdf2 .}$

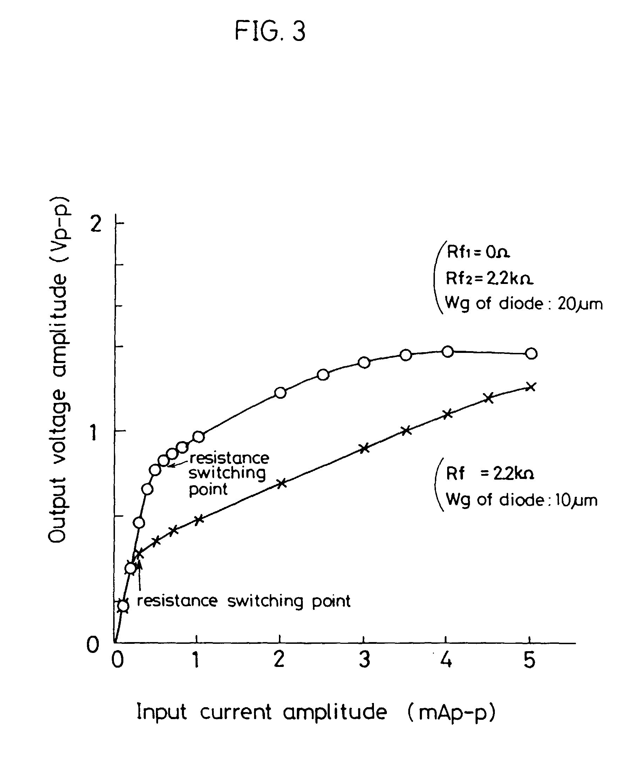

Figure 3 shows characteristics of an output voltage amplitude against an input current amplitude of the preamplifier 30 and the prior art preamplifier 20. In the figure, a curve obtained by connecting between points of white dot ○ is a characteristic curve of this preamplifier 30 and a curve obtained by connecting between points of crossed mark × is a characteristic curve of the prior art preamplifier 20 shown in Figure 17. Here, in the preamplifier 30, a size of the diodes 7a and 7b, namely a gate width Wg is made 20 microns which is twice as wide as that of the diode 7 of the prior art preamplifier 20 (gate width Wg=10 microns), and thus the resistance value of the diode part (diodes 7a and 7b) is equalized to a resistance value 360Ω of the diode part of the prior art preamplifier 20. Further, a resistance value of the feedback resistor 3a is made 0Ω and a resistance value of the feedback resistor 3b is made 2.2kΩ so as to equalize the whole resistance value to a feedback resistance value of the feedback resistor 3 of the prior art preamplifier 20. The amplifier is operated further in a transmission speed of 622 Mb/s.

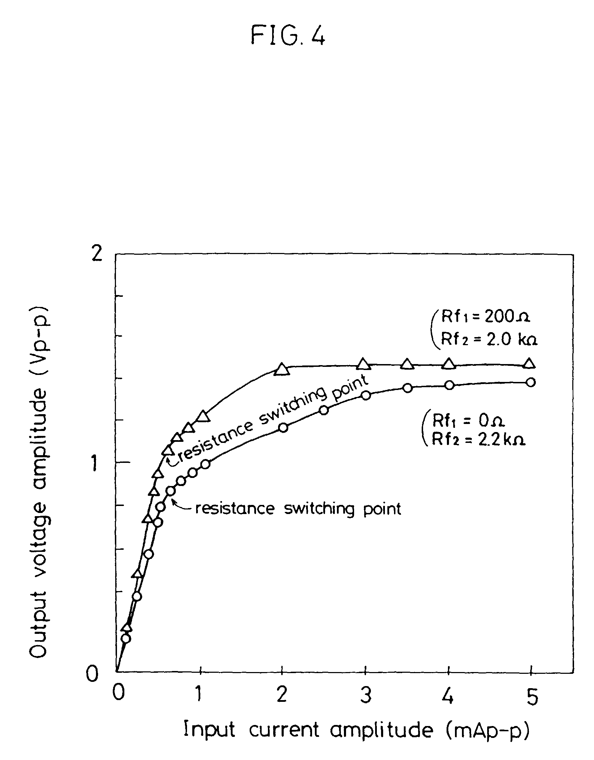

As is apparent from this Figure, in this preamplifier 30, an input current amplitude (an input signal level) when a substantive feedback resistance value Rfs is switched from 2.2kΩ to 360Ω, is 0.6mAp-p which is twice as large as the value (0.03mAp-p) of the prior art preamplifier 20 in which a single diode of 360Ω is connected in parallel with the feedback resistor 3. While two diodes 7a and 7b are connected in series to each other in parallel with the feedback resistor 3b, three or more diodes can be connected in series to each other in parallel with the feedback resistor 3b. In this case, an input signal level at which the substantive feedback resistance value is switched, increases, like 0.9mA, 1.2mA, ..., in proportion to the number of diodes. While the value of the feedback resistor 3a is made 0Ω in obtaining a characteristic curve shown in Figure 3 in order to effectuate the comparison with the prior art, by fixing the values of the feedback resistors 3a and 3b respectively, for example, at 200Ω and 2.0kΩ to increase the substantive feedback resistance value Rfs in "on" state of the diodes 7a and 7b, it is possible to change the ratio of a change of the output voltage amplitude against a change of the input current amplitude (namely, amplification factor), before and after the substantive feedback resistance value Rfs is switched, as represented by a characteristic curve of the output voltage amplitude against the input current amplitude (Δ-Δ) shown in Figure 4. A curve obtained by connecting between points of white dot ⃝ in Figure 4 is the same as a characteristic curve of Figure 3. In the preamplifier of this embodiment, since a plurality of diodes are connected in parallel with the feedback resistor 3 in series to each other, in a process of producing the preamplifier, by deciding properly the number of diodes which are connected, not only an input dynamic range can be enlarged but also an input signal level at which the feedback resistance value is switched, can be changed with paying consideration on an amplification characteristic of the amplifier. In addition, since not all the feedback resistors connected in parallel with the voltage amplifier 2 but a part of the resistors, namely the feedback resistor 3b in the two feedback resistors 3a and 3b, which are connected in series to each other, is connected to the diode, an input dynamic range can be enlarged while considering amplification factors, before and after the substantive feedback resistance value Rfs is switched.

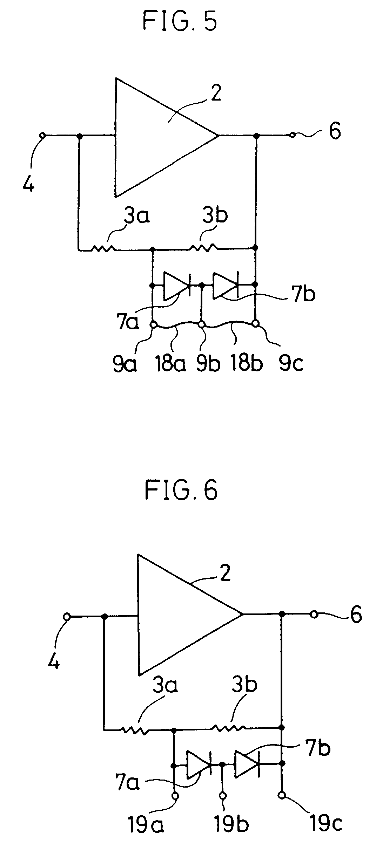

Figure 5 is a block diagram showing a constitution of a preamplifier in accordance with a second embodiment of the present invention. In the Figure, the same reference numerals as those of Figure 1 designate the same or corresponding parts. In a preamplifier 1d, fuses 18a and 18b are connected in parallel respectively with diodes 7a and 7b. Numerals 9a, 9b and 9c designate connection terminals.

In the preamplifier 1d of this embodiment, fuses 18a and 18b are connected in parallel respectively with diodes 7a and 7b which are connected in series to each other in parallel with the feedback resistor 3b. Therefore, in an optical communication system, namely an optical linking system or the like, is constructed employing an optical receiver including the preamplifier 1d, by carrying out a laser trimming of either or both of the fuses 18a and 18b in practical use, it is possible to selectively switch to forward an input signal to either or both of the diodes, thereby to adjust the switching point of the substantive feedback resistance value Rfs. In addition, by differentiating internal resistance values Rdf1 and Rdf2 of the diodes 7a and 7b from each other, the amplification factor of the amplifier can be changed before and after the substantive feedback resistance value Rfs is switched.

While two diodes are employed in the above-described second embodiment, when three or more diodes are connected in series to each other in parallel with the feedback resistor and fuses are connected in parallel with the respective diodes, there are provided an increased number of switching points of the substantive feedback resistance value Rfs, and thus an increased number of amplification factors before and after the switching points can be obtained with relative to the above-described second embodiment.

Figure 6 is a block diagram showing a constitution of a preamplifier in accordance with a third embodiment of the present invention. In the Figure, the same reference numerals as those of Figure 1 designate the same or corresponding parts. In a preamplifier 1e, bonding pads 19a and 19b are connected respectively to an input and an output sides of the photodiode 7a and bonding pads 19b and 19c are connected respectively to an input and an output sides of the photodiode 7b.

In the preamplifier 1e of this embodiment, similarly as in the above-described second embodiment, in an optical communication system, namely an optical linking system or the like, employing an optical receiver including the preamplifier 1e, by conducting a wire bonding either between the bonding pads 19a and 19b or between the bonding pads 19b and 19c, an input signal can be forwarded to only either of the diodes, thereby adjusting the switching point of the substantive feedback resistance value Rfs. In addition, similarly as in the second embodiment, by differentiating internal resistance values Rdf1 and Rdf2 of the diodes 7a and 7b from each other, there are provided different amplification factors of the amplifier before and after the substantive feedback resistance value Rfs is switched.

While two diodes are employed in the above-described third embodiment, when three or more diodes are connected in series to each other in parallel with the feedback resistor and the bonding pads are connected to the input and output sides of the respective diodes, there are provided increased number of switching points of the substantive feedback resistance value Rfs and amplification factor before and after the switching points are changed with relative to the above-described third embodiment.

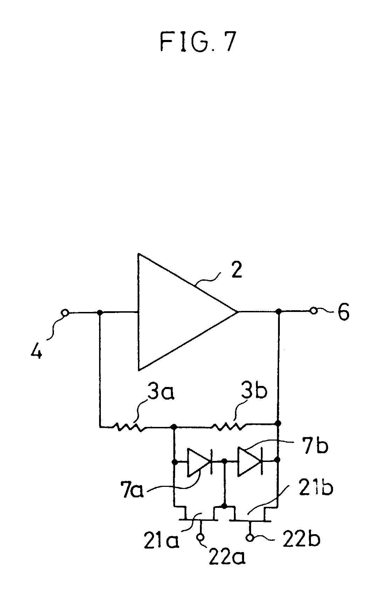

Figure 7 is a block diagram showing a constitution of a preamplifier in accordance with a fourth embodiment of the present invention. In the Figure, the same reference numerals as those of Figure 1 designate the same or corresponding parts. In a preamplifier 1f of this embodiment, FETs 21a and 21b as a switching element are connected in parallel respectively with the diodes 7a and 7b. Numerals 22a and 22b designate gate bias terminals.

In the preamplifier 1f of this embodiment in an optical communication system, namely an optical linking system or the like, employing an optical receiver including the preamplifier 1f, by controlling "on" or "off" state of FETs 21a and 21b by an external signal applied to the gate bias terminals 22a and 22b, it is possible to selectively switch to forward an input signal to either or both of the diodes, thereby to adjust the switching point of the substantive feedback resistance value Rfs in accordance with the operation of the system. In addition, similarly as in the second embodiment, by differentiating internal resistance values Rdf1 and Rdf2 of the diodes 7a and 7b from each other, an increased number of amplification factors of the amplifier are provided before and after the substantive feedback resistance value Rfs is switched.

While two diodes are employed in the above-described fourth embodiment, when three or more diodes are connected in series to each other in parallel with the feedback resistor and the FETs are connected in parallel with the respective diodes, there are provided increased number of switching points of the substantive feedback resistance value Rfs and amplification factors before and after the switching points are changed with relative to the above-described fourth embodiment.

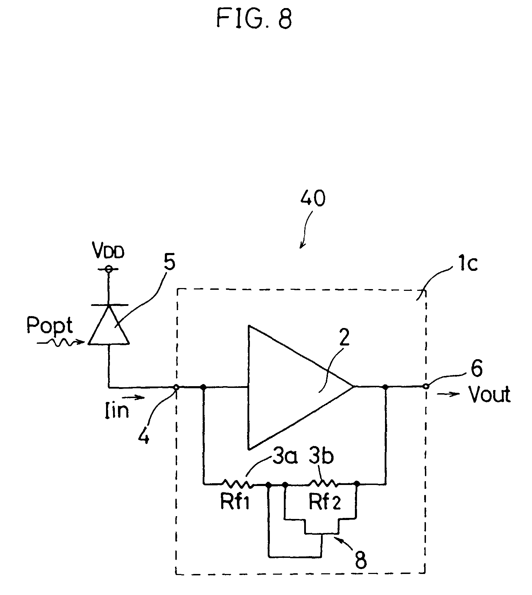

Figure 8 is a block diagram showing an optical receiver employing a preamplifier in accordance with a fifth embodiment of the present invention. In the Figure, the same reference numerals as those of Figure 1 designate the same or corresponding parts. An optical receiver 40 comprises a preamplifier 1c and the photodiode 5. The preamplifier 1c includes the voltage amplifier 2, feedback resistors 3a and 3b which are connected in parallel with the voltage amplifier 2 and are connected in series to each other and an enhancement type FET 8 (hereinafter also referred to as EFET) which is connected in parallel with the feedback resistor 3b such that short-circuited drain and gate of the FET 8 are connected to an input side of the voltage amplifier 2 and a source thereof is connected to an output side of the voltage amplifier 2.

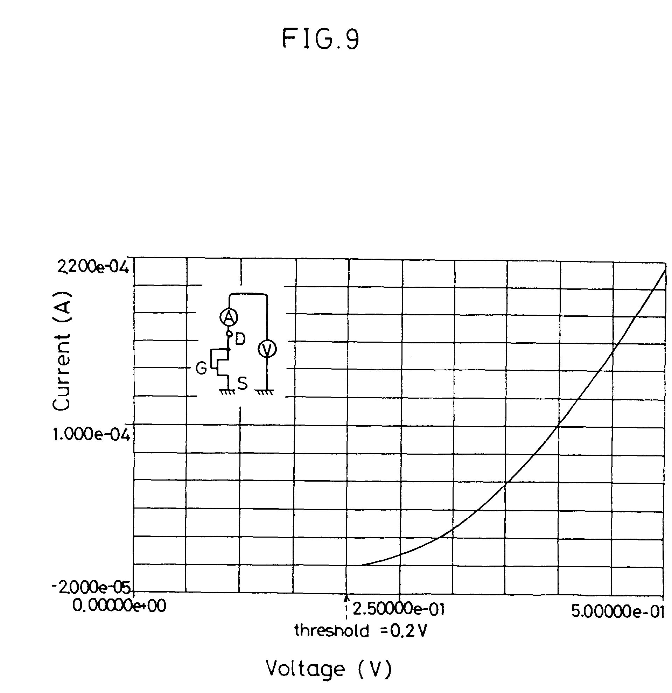

As shown in Figure 9 showing a voltage and a current characteristic of the enhancement type FET 8, the EFET 8 is an n-channel enhancement type FET which is designed so that a current starts to flow when a voltage applied to the EFET exceeds a threshold voltage Vth (0.2V).

A description is given of operations.

The fundamental operations are the same as those of the prior art optical receiver 20 shown in Figure 17.

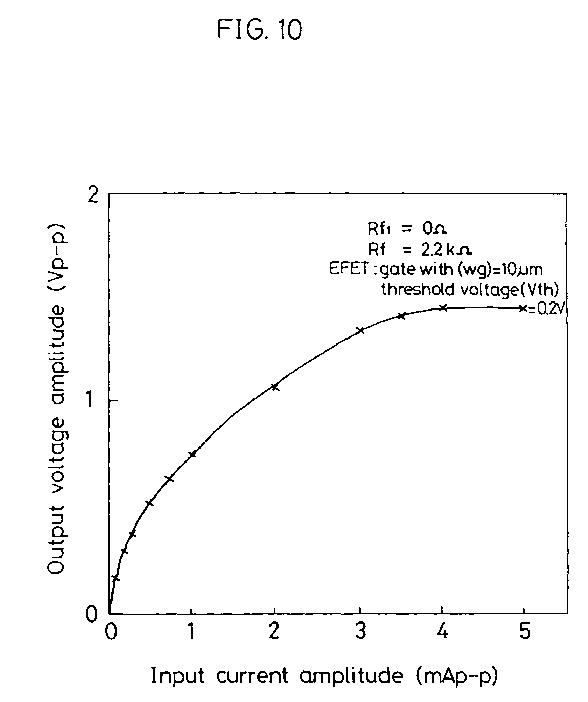

When an input signal which is input from the photodiode 5 into the preamplifier 1c increases and a voltage drop in the feedback resistor 3b becomes larger than the threshold voltage (0.2V) of the enhancement type FET 8 in accordance with an increase in the input signal, a current starts to flow through the enhancement type FET 8 and the substantive feedback resistance value Rfs begins to vary. Figure 10 is a diagram showing a characteristic of an output voltage amplitude against an input current amplitude of the preamplifier 1c. Here, the feedback resistance value Rf1 of the feedback resistor 3a is 0Ω, the feedback resistance value Rf2 of the feedback resistor 3b is 2.2kΩ, a drain resistance of the EFET 8 is 122Ω, and a source resistance thereof is 122Ω. As shown in the figure, in this preamplifier 1c, when an input current is 0.1mAp-p and a voltage drop in the feedback resistor 3b is above 0.2V, a current gradually begins to flow through the EFET 8 connected in parallel with the feedback resistor 3b and the substantive feedback resistance value starts to vary from this point. Thereafter, according as the input current increases and the voltage drop in the feedback resistor 3b increases further, the current flowing through the EFET 8 increases and the result is that the substantive feedback resistance value Rfs gradually reduces. Here, the EFET 8 is designed to have a threshold voltage Vth of 0.2V, but this threshold voltage Vth can be properly changed at the production step.

In the preamplifier of this embodiment, at a point when the voltage drop in the feedback resistor 3b becomes larger than the threshold voltage of the enhancement type FET 8, the current gradually begins to flow through the enhancement type FET 8 (in other words, the substantive feedback resistance value Rfs is switched) and with the increase in the input signal, the substantive feedback resistance value Rfs is gradually reduced. As a result, before and after the substantive feedback resistance value is switched, an amplification factor of the amplifier can be gradually reduced and an input dynamic range can be enlarged keeping an amplification characteristic close to a linear characteristic.

In any of the above-described embodiments, since not all the feedback resistors connected in parallel with the voltage amplifier 2 but a part of the resistors, namely the feedback resistor 3b, among the two feedback resistors 3a and 3b which are connected in series to each other, is connected to the EFET, by adjusting the resistance values of the feedback resistors 3a and 3b in the production process, the input dynamic range can be enlarged with considering amplification factors before and after the substantive feedback resistance value Rfs is switched.

As described above, in accordance with the present invention, since a plurality of diodes connected in series to each other are connected in parallel with a feedback resistor arranged in parallel with a voltage amplifier such that an anode side of the diodes is connected to an input side of a voltage amplifier and a cathode thereof to an output side of the voltage amplifier, an input signal level at which a substantive feedback resistance value is switched, can be changed in accordance with the number of diodes, thereby enlarging an input dynamic range with considering a sensitivity of the amplifier (an output voltage amplitude) or an amplification factor.

Further, in accordance with the present invention, since a fuse is connected in parallel with each of the diodes which are connected in series to each other, by carrying out a laser trimming of the desired fuse in operating the amplifier, an input signal level at which the substantive feedback resistance value is switched, can be changed, thereby resulting in a more practical preamplifier which can enlarge an input dynamic range considering a sensitivity of the amplifier (an output voltage amplitude) or an amplification factor.

Still, in accordance with the present invention, since bonding pads are connected respectively to an input and an output side of each of the diodes which are connected in series to each other, by conducting a wire bonding between the desired bonding pads in operating the amplifier, an input signal level at which the substantive feedback resistance value is switched, can be changed, to result in a more practical preamplifier which can enlarge an input dynamic range considering a sensitivity of the amplifier (an output voltage amplitude) or an amplification factor.

Yet, in accordance with the present invention, since an FET is connected in parallel with each of the diodes, by controlling "on" or "off" state of the FET with an external signal applied to a gate of the FET in operating the amplifier, an input signal level at which the substantive feedback resistance value is switched, can be changed, to result in a more practical preamplifier which can enlarge an input dynamic range considering a sensitivity of the amplifier (an output voltage amplitude) or an amplification factor.

Still further, in accordance with the present invention, since an enhancement type FET is connected in parallel with a feedback resistor connected in parallel with a voltage amplifier such that a drain and a gate thereof FET are connected to an input side of the voltage amplifier and a source thereof is connected to an output side of the voltage amplifier, a substantive feedback resistance value does not rapidly change and an enlarged input dynamic range is obtained keeping an amplification characteristic close to a linear characteristic.

## Claims

1. An optical receiver preamplifier for converting an input photo current signal into a voltage signal and outputting the voltage signal, comprising:
a voltage amplifier (2);
a feedback resistor connected in parallel between an input terminal and an output terminal of said voltage amplifier (2); and
a plurality of diodes (7a, 7b) which are connected in series to each other and are connected in parallel with said feedback resistor so that an anode side of the diodes (7a, 7b) is connected at an input side of said voltage amplifier (2) and a cathode side of the diodes is connected at an output side of said voltage amplifier (2), characterised in that
said feedback resistor comprises a plurality of resistors (3a, 3b) connected in series and said diodes (7a, 7b) are connected in parallel with one (3b) of said resistors.

2. The preamplifier of claim 1 wherein a fuse (18a, 18b) is connected in parallel with each of said diodes (7a, 7b) which are connected in series to each other.

3. The preamplifier of claim 1 wherein a bonding pad is connected with each of an input side and an output side of each of said diodes which are connected in series to each other.

4. The preamplifier of claim 1 wherein a bonding pad (19a, 19b, 19c) is connected with each of an input side and an output side of each of said diodes (7a, 7b) which are connected in series to each other.

5. The preamplifier of claim 1 wherein an FET (21a, 21b) is connected in parallel with each of said diodes (7a, 7b) which are connected in series to each other.

6. The preamplifier of claim 1 wherein an optical receiver (5) arranged to generate said input current signal (In) is connected to an input terminal of said voltage amplifier (2).

7. An optical receiver preamplifier for converting an input photo current signal into a voltage signal which is to be output, comprising:
a voltage amplifier (2); and
a feedback resistor connected in parallel between an input terminal and output terminal of said voltage amplifier (2), characterised in that
said feedback resistor comprises a plurality of resistors (3a, 3b) which are connected in series to each other and connected in parallel between an input terminal (4) and an output terminal (6) of said voltage amplifier (2); and characterised in that
an enhancement type field effect transistor (8) which is connected in parallel with one (3a) of said resistors (3a, 3b) of said feedback resistor so that a drain and a gate of said enhancement type field effect transistor are connected at an input side of said voltage amplifier (2) and a source thereof is connected at an output side of said voltage amplifier (2).

8. The preamplifier of claim 9 wherein an optical receiver arranged to generate said current signal (In) is connected to an input terminal (4) of said voltage amplifier (2).

## Revendications

1. Préamplificateur de récepteur optique pour convertir un signal de photocourant d'entrée en un signal de tension et produire le signal de tension, comprenant :
un amplificateur de tension (2);
une résistance de contre-réaction reliée en parallèle entre une borne d'entrée et une borne de sortie dudit amplificateur de tension (2); et
un certain nombre de diodes (7a, 7b) qui sont reliées en série les unes aux autres et sont reliées en parallèle avec ladite résistance de contre-réaction de sorte qu'un côté anode des diodes (7a, 7b) est relié à un côté entrée dudit amplificateur de tension (2) et qu'un côté cathode des diodes est relié à un côté sortie dudit amplificateur de tension (2), caractérisé en ce que
ladite résistance de contre-réaction comprend un certain nombre de résistances (3a, 3b) reliées en série et lesdites diodes (7a, 7b) sont reliées en parallèle à l'une (3b) desdites résistances.

2. Préamplificateur de la revendication 1, dans lequel un fusible (18a, 18b) est relié en parallèle à chacune des diodes précitées (7a, 7b) qui sont reliées en série les unes aux autres.

3. Préamplificateur de la revendication 1 dans lequel une plage de connexion est reliée à chaque côté entrée et chaque côté sortie de chacune des diodes précitées qui sont reliées en série les unes aux autres.

4. Préamplificateur de la revendication 1 dans lequel une plage de connexion (19a, 19b, 19c) est reliée à chaque côté entrée et chaque côté sortie de chacune des diodes précitées (7a, 7b) qui sont reliées en série les unes aux autres.

5. Préamplificateur de la revendication 1 dans lequel un FET (21a, 21b) est relié en parallèle à chacune des diodes précitées (7a, 7b) qui sont reliées en série les unes aux autres.

6. Préamplificateur de la revendication 1 dans lequel un récepteur optique (5) agencé pour produire le signal de courant d'entrée précité (In) est relié à une borne d'entrée de l'amplificateur de tension précité (2).

7. Préamplificateur de récepteur optique pour convertir un signal de photocourant d'entrée en un signal de tension qui doit être produit, comprenant :
un amplificateur de tension (2); et
une résistance de contreréaction reliée en parallèle entre une borne d'entrée et une borne de sortie dudit amplificateur de tension (2), caractérisé en ce que ladite résistance de contreréaction comprend un certain nombre de résistances (3a, 3b) qui sont reliées en série les unes aux autres et reliées en parallèle entre une borne d'entrée (4) et une borne de sortie (6) dudit amplificateur de tension (2); et caractérisé en ce que
un transistor à effet de champ du type à enrichissement (8) est relié en parallèle à l'une (3a) desdites résistances (3a, 3b) de ladite résistance de contreréaction de sorte qu'un drain et une grille dudit transistor à effet de champ du type à enrichissement sont reliés à un côté entrée dudit amplificateur de tension (2) et une source de celui-ci est reliée à un côté sortie dudit amplificateur de tension (2).

8. Préamplificateur de la revendication 9 dans lequel un récepteur optique agencé pour produire le signal de courant précité (In) est relié à une borne d'entrée (4) de l'amplificateur de tension précité (2).

## Patentansprüche

1. Optischer Empfängervorverstärker zum Umwandeln eines Eingangsfotostromsignals in ein Spannungssignal und zum Ausgeben des Spannungssignals, mit:
einem Spannungsverstärker (2);
einem Rückkopplungswiderstand, welcher parallel zwischen einem Eingangsanschluß und einem Ausgangsanschluß des Spannungsverstärkers (2) angeschlossen ist; und
einer Mehrzahl von Dioden (7a, 7b), welche in Reihe miteinander und parallel mit dem Rückkopplungswiderstand derart verbunden sind, daß eine Anode der Dioden (7a, 7b) mit einem Eingang des Spannungsverstärkers (2) verbunden ist und eine Kathode der Dioden mit einem Ausgang des Spannungsverstärkers (2) verbunden ist, dadurch gekennzeichnet, daß
der Rückkopplungswiderstand eine Mehrzahl von in Reihe miteinander verbundenen Widerständen (3a, 3b) aufweist und die Dioden (7a, 7b) parallel mit einem (3b) der Widerstände verbunden sind.

2. Vorverstärker nach Anspruch 1, dadurch gekennzeichnet, daß eine Sicherung (18a, 18b) parallel an jede der Dioden (7a, 7b) angeschlossen ist, welche in Reihe miteinander verbunden sind.

3. Vorverstärker nach Anspruch 1, dadurch gekennzeichnet, daß eine Bondinsel mit jedem Eingang und Ausgang jeder der Dioden verbunden ist, welche in Reihe miteinander verbunden sind.

4. Vorverstärker nach Anspruch 1, dadurch gekennzeichnet, daß eine Bondinsel (19a, 19b, 19c) mit jedem Eingang und Ausgang jeder der Dioden (7a, 7b) verbunden ist, welche in Reihe miteinander verbunden sind.

5. Vorverstärker nach Anspruch 1, dadurch gekennzeichnet, daß ein FET (21a, 21b) parallel mit jeder der Dioden (7a, 7b) verbunden ist, welche in Reihe miteinander verbunden sind.

6. Vorverstärker nach Anspruch 1, dadurch gekennzeichnet, daß ein zum Erzeugen des Eingangsstromsignals (In) angeordneter optischer Empfänger (5) mit einem Eingangsanschluß des Spannungsverstärkers (2) verbunden ist.

7. Optischer Empfängervorverstärker zum Umwandeln eines Eingangsfotostromsignals in ein Spannungssignal, welches auszugeben ist, mit:
einem Spannungsverstärker (2); und
einem Rückkopplungswiderstand, welcher parallel zwischen einem Eingangsanschluß und einem Ausgangsanschluß des Spannungsverstärkers (2) angeschlossen ist, dadurch gekennzeichnet, daß
der Rückkopplungswiderstand eine Mehrzahl von Widerständen (3a, 3b) aufweist, welche in Reihe miteinander verbunden sind und parallel zwischen einem Eingangsanschluß (4) und einem Ausgangsanschluß (6) des Spannungsverstärkers (2) angeschlossen sind, dadurch gekennzeichnet, daß
ein Feldeffekttransistor (8) eines Anreicherungstyps parallel mit einem (3a) der Widerstände (3a, 3b) des Rückkopplungswiderstands derart verbunden ist, daß ein Drain und ein Gate des Feldeffekttransistors eines Anreichungstyps mit einem Eingang des Spannungsverstärkers (2) und ein Source davon mit einem Ausgang des Spannungsverstärkers (2) verbunden sind.

8. Vorverstärker nach Anspruch 9, dadurch gekennzeichnet, daß ein zum Erzeugen des Stromsignals (In) angeordneter optischer Empfänger mit einem Eingangsanschluß (4) des Spannungsverstärkers (2) verbunden ist.
